(19) Europäisches Patentamt
European Patent Office
Office européen des brevets

(11) Veröffentlichungsnummer: **0 288 861 B1**

(12) **EUROPÄISCHE PATENTSCHRIFT**

(45) Veröffentlichungstag der Patentschrift: **18.09.91**

(51) Int. Cl.⁵: **G01R 33/50**

(21) Anmeldenummer: **88106146.9**

(22) Anmeldetag: **18.04.88**

(54) Kernspin-Tomographiegerät.

(30) Priorität: **30.04.87 DE 3714368**

(43) Veröffentlichungstag der Anmeldung:
**02.11.88 Patentblatt 88/44**

(45) Bekanntmachung des Hinweises auf die
Patenterteilung:
**18.09.91 Patentblatt 91/38**

(84) Benannte Vertragsstaaten:
**DE FR NL**

(56) Entgegenhaltungen:
**EP-A- 0 191 431**
**JP-A-60 029 685**

**ELECTROMEDICA, Band 54, Nr. 1, 1986, Seiten 15-18, Erlangen, DE; A. OPPELT et al.: "FISP: eine neue schnelle Pulssequenz für die Kernspintomographie"**

**MAGNETIC RESONANCE IN MEDICINE, Band 4, Nr. 1, Januar 1987, Seiten 9-23, Academic Press, Inc., New York, US; R.C. HAWKES: "Rapid Fourier imaging using steady-state free precession"**

**JOURNAL OF MAGNETIC RESONANCE, Band 72, Nr. 2, April 1987, Seiten 307-314, Acade-**

**mic Press, Inc., Duluth, MN, US; J. FRAHM et al.: "Transverse coherence in rapid FLASH NMR imaging"**

(73) Patentinhaber: **Siemens Aktiengesellschaft**
**Wittelsbacherplatz 2**
**W-8000 München 2(DE)**

(72) Erfinder: **Oppelt, Arnulf, Dr.**
**Schwedenstrasse 25**
**W-8521 Spardorf(DE)**
Erfinder: **Fischer, Hubertus**
**Moltkestrasse 2**
**W-8520 Erlangen(DE)**
Erfinder: **Barfuss, Helmut, Dr.**
**Widerlichstrasse 22**
**W-8520 Erlangen(DE)**

## Beschreibung

Die Erfindung betrifft ein Verfahren zum Betrieb eines Kernspin-Tomographiegeräteszur Untersuchung eines Objektes mit Hilfe der kernmagnetischen Resonanz.

In jüngster Zeit sind sogenannte schnelle Bildgebungssequenzen für die Kernspin-Tomographie bekannt geworden. So wurde z.B. in "Haase A. et al, Rapid Images and NMR-Movies, SMRM, Fourth Annual Meeting, 1985, Book of Abstracts (1985) 980" die sogenannte FLASH-Sequenz beschrieben. Dabei erfolgt die Anregung der Kernresonanz mit HF-Impulsen mit Flip-Winkeln deutlich kleiner als 90° bei möglichst rascher Repetition. Der Bildkontrast ist durch die Längsrelaxationszeit $T_1$ bestimmt.

Von Oppelt A. et al wurde in dem Artikel "FISP-a new MRI-Sequence, Elektromedica 54 (1986/1)" die sogenannte FISP-Sequenz beschrieben. Dabei wird im Gegensatz zur FLASH-Sequenz das Phasengedächtnis des Spinsystems durch Refokussierung des Codiergradienten ausgenutzt, um ein Bild zu erhalten, das vom Verhältnis der Längsrelaxationszeit zur Querrelaxationszeit ($T_1/T_2$) geprägt ist. Die Pulssequenz für einen Scan läuft wie folgt ab: Während eines ersten Zeitabschnittes wird unter der Wirkung eines Schichtselektionsgradienten ein Hochfrequenzimpuls eingestrahlt. Nach jedem Hochfrequenzimpuls wird während eines zweiten Zeitabschnittes der Schichtselektionsgradient invertiert, um die durch diesen verursachte Dephasierung rückgängig zu machen. Ferner wird ein erster Phasencodiergraident eingeschaltet. Ein invertierter Auslesegradient dephasiert die Spins in Ausleserichtung. In einem dritten Zeitabschnitt werden durch einen Auslesegradienten die Spins wieder rephasiert und es entsteht ein Echosignal, das zur Bildgewinnung ausgewertet wird. In einem vierten Zeitabschnitt wird ein invertierter Schichtselektionsgradient, ein zweiter Phasencodiergradient und ein invertierter Auslesegradient eingeschaltet. Der zweite Phasencodiergradient ist gegenüber dem ersten Phasencodiergradienten invertiert.

Diese Pulssequenz wird mit unterschiedlichen Werten des Phasencodiergradienten mehrfach wiederholt.

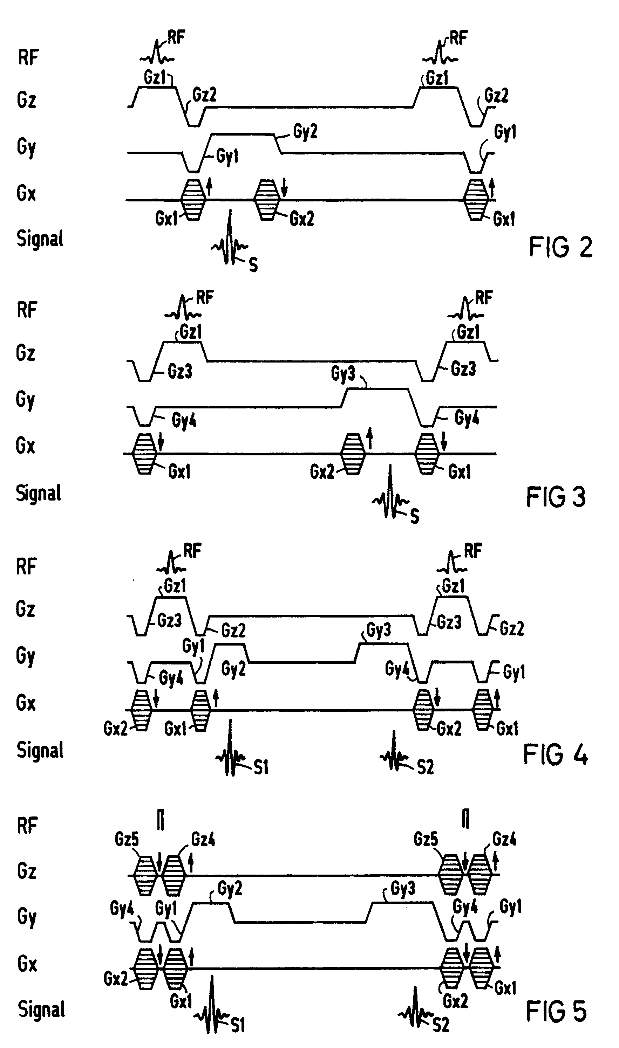

In FIG 2 ist eine in der Praxis zum Einsatz kommende FISP-Sequenz dargestellt. Dabei wird das Untersuchungsobjekt zur Anregung der Kernspinresonanz mit einer Folge von Hochfrequenzimpulsen RF beaufschlagt. Gleichzeitig mit jedem Hochfrequenzimpuls wird ein Schichtauswahlgradient $G_{z1}$ eingeschaltet, so daß jeweils nur eine durch ihre z-Koordinate festgelegte Schicht des Untersuchungsobjektes angeregt wird. Nach erfolgter Anregung wird ein gegenüber dem Schichtauswahlgradienten $G_{z1}$ negativer Gradientenimpuls $G_{z2}$ eingeschaltet. Hierbei wird die durch den Schichtauswahlgradienten $G_{z1}$ verursachte Dephasierung des Spinsystems wieder rückgängig gemacht.

Gleichzeitig mit dem Gradientenimpuls $G_{z2}$ wird ein negativer Gradientenimpuls $G_{y1}$ und ein Phasencodiergradient $G_{x1}$ eingeschaltet. Mit dem Gradientenimpuls $G_{y1}$ wird das Spinsystem dephasiert und somit das auf den Hochfrequenzimpuls RF folgende FID-Signal zerstört. Der Phasencodiergradient $G_{x1}$ wird nach jedem Hochfrequenzimpuls RF weitergeschaltet und prägt dem Spinsystem eine Phaseninformation ein. Auf den negativen Gradientenimpuls $G_{y1}$ folgt ein positiver Gradientenimpuls $G_{y2}$, der die Dephasierung durch den Gradientenimpuls $G_{y1}$ wieder rückgängig macht und somit ein Spin-Echo und damit ein auswertbares Signal $S_1$ erzeugt. Nach Abklingen des Signals wird ein zweiter Phasencodiergradient $G_{x2}$ eingeschaltet, der gegenüber dem ersten Phasencodiergradienten $G_{x1}$ invertiert ist. Damit wird die vom ersten Phasencodiergradienten $G_{x1}$ verursachte Dephasierung wieder rückgängig gemacht.

Von Gyngell et al wurde bei der SMRM-Tagung 1986 in Montreal (Gyngell et al "The Application of Steady-State Free Precession (SFP) in 2 D - FT MR Imaging", SMRM, 5th Annual Meeting 1986, Book of Abstracts (1986) 666) eine modifizierte FISP-Sequenz unter dem Namen CE FAST vorgestellt, die in FIG 3 gezeigt ist. Auch hierbei werden Hochfrequenzimpulse in kurzer Folge nacheinander gleichzeitig mit einem Schichtauswahlgradienten $G_{z1}$ eingestrahlt. Jedem Schichtauswahlgradienten $G_{z1}$ geht ein negativer Gradientenimpuls $G_{z3}$ voraus, der die mit dem Schichtauswahlgradienten $G_{z1}$ verursachte Dephasierung kompensiert. Ferner geht jedem Hochfrequenzimpuls RF ein negativer Gradientenimpuls $G_{y4}$ und ein Phasencodiergradient $G_{x1}$ voraus. Nach jedem Hochfrequenzimpuls RF wird ein positiver Gradientenimpuls $G_{y3}$ zusammen mit einem gegenüber dem ersten Phasencodiergradienten $G_{x1}$ invertierten Phasencodiergradienten $G_{x2}$ eingeschaltet. Damit entsteht ein in "Freeman R., Hill, H.D.W., Phase and Intensity Anomalies in Fourier Transform NMR, Journal of Magnetic Resonance, 4 (1971) 366 - 383" dargestelltes halbes Echosignal, das durch die Wirkung der Gradientenimpulse $G_{y4}$ und $G_{y3}$ zu einem vollen Echo geformt wird.

Mit der FISP-Sequenz nach FIG 2 lassen sich $T_1/T_2$-gewichtete Bilder, mit der CE FAST-Sequenz nach FIG 3 $T_2$-gewichtete Bilder mit jeweils unterschiedlichem Informationsgehalt herstellen.

Aufgabe der Erfindung ist es, den Informationsgehalt beider Verfahren ohne Verlängerung der Meßzeit zu erhalten.

Diese Aufgabe wird durch die Merkmale des Patentanspruchs 1 gelöst. Dabei ist das erste Signal $S_1$ $T_1/T_2$-gewichtet, während das zweite Si-

gnal $S_2$ $T_2$-gewichtet ist. Bei praktisch unveränderter Meßzeit kann man somit zwei Bilder mit unterschiedlichem $T_2$-Kontrast und damit erhöhtem diagnostischen Wert erzeugen.

In einer vorteilhaften Ausführungsform nach Anspruch 2 erfolgt die Auflösung in der dritten Dimension durch Anwendung von Schichtauswahlgradienten.

Eine Aufnahme eines dreidimensionalen Datensatzes ist bei einer Ausführung gemäß Anspruch 3 möglich.

Ein Ausführungsbeispiel der Erfindung wird nachfolgend anhand der FIG 1, 3 und 4 näher erläutert. Es zeigen:

FIG 1    den schematischen Aufbau eines Kernspin-Tomographiegerätes,

FIG 4    eine Anregesequenz gemäß einem ersten Ausführungsbeispiel der Erfindung,

FIG 5    eine Anregesequenz gemäß einem zweiten Ausführungsbeispiel der Erfindung.

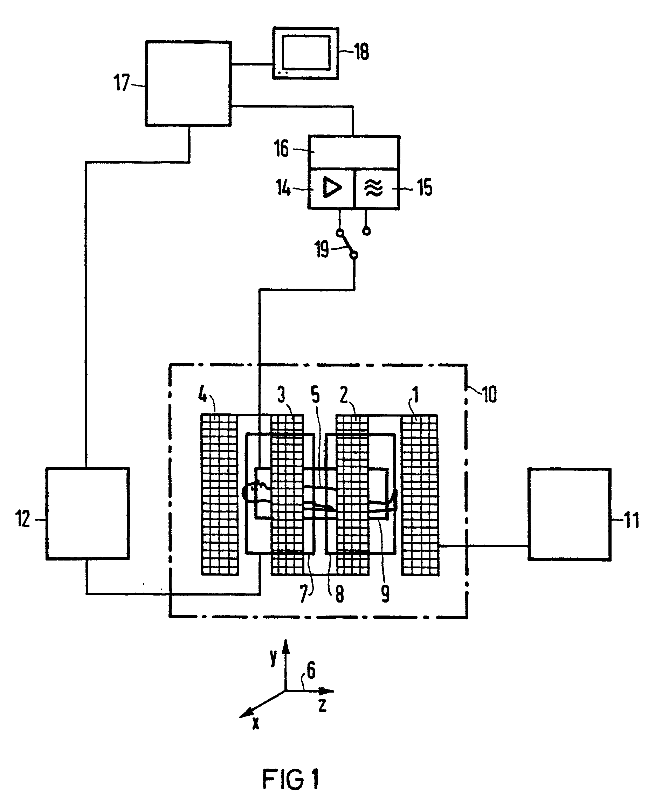

Die FIG 1 zeigt schematisch den prinzipiellen Aufbau eines Kernspin-Tomographiegerätes für die Erstellung von Bildern eines Untersuchungsobjektes. Die Spulen 1 bis 4 erzeugen ein magnetisches Grundfeld $B_0$, in welchem sich bei Anwendung zur medizinischen Diagnostik der zu untersuchende Körper 5 eines Patienten befindet. Diesem sind außerdem Gradientenspulen zugeordnet, die zur Erzeugung unabhängiger, zueinander senkrechter Magnetfeldgradienten der Richtungen x,y und z gemäß dem Koordinatenkreuz 6 vorgesehen sind. In der FIG sind der Übersichtlichkeit halber nur die Gradientenspulen 7 und 8 gezeichnet, die zusammen mit einem Paar gegenüberliegender, gleichartiger Gradientenspulen zur Erzeugung des x-Gradienten dienen. Die gleichartigen, nicht gezeichneten y-Gradientenspulen liegen parallel zum Körper 5 und oberhalb sowie unterhalb von ihm, die für das z-Gradientenfeld quer zu seiner Längsachse am Kopf- und am Fußende.

Die Anordnung enthält außerdem noch eine zur Erzeugung und Aufnahme der Kernresonanzsignale dienende Hochfrequenzspule 9. Die von einer strichpunktierten Linie 10 umgrenzten Spulen 1,2,3,4,7,8 und 9 stellen das eigentliche Untersuchungsinstrument dar.

Es wird von einer elektrischen Anordnung aus betrieben, die ein Netzgerät 11 zum Betrieb der Spulen 1 bis 4 sowie eine Gradientenstromversorgung 12, an welcher die Gradientenspulen 7 und 8 sowie die weiteren Gradientenspulen liegen, umfaßt. Die Meßspule 9 ist über einen Signalverstärker 14 bzw. einen Hochfrequenzsender 15 an einen Prozeßrechner 17 gekoppelt, an dem zur Ausgabe der Abbildung ein Bildschirmgerät 18 angeschlossen ist. Die Komponenten 14 und 15 bilden eine Hochfrequenzeinrichtung 16 zur Signalerzeugung und -aufnahme. Ein Umschalter 19 ermöglicht das Umschalten von Sende- auf Empfangsbetrieb.

FIG 4 zeigt ein erstes Ausführungsbeispiel der Erfindung. Dabei wird eine Folge von Hochfrequenzimpulsen RF auf das Untersuchungsobjekt eingestrahlt, wobei jeweils gleichzeitig ein Schichtauswahlgradient $G_{z1}$ eingeschaltet wird. Jedem Hochfrequenzimpuls RF gehen negative Gradientenimpulse $G_{z3}$ und $G_{y4}$ sowie ein von Hochfrequenzimpuls zu Hochfrequenzimpuls in der Amplitude variierter Phasencodiergradient $G_{x2}$ voraus. Nach jedem Hochfrequenzimpuls RF folgen negative Gradientenimpulse $G_{z2}$ und $G_{y1}$ sowie ein Phasencodiergradient $G_{x1}$, der gegenüber dem Phasencodiergradienten $G_{x2}$ invertiert ist. Auf den negativen Gradientenimpuls $G_{y1}$ folgt ein positiver Gradientenimpuls $G_{y2}$ und dem negativen Gradientenimpuls $G_{y4}$ geht ein positiver Gradientenimpuls $G_{y3}$ voraus.

Mit der Serie von selektiven Hochfrequenzimpulsen $RF_n$ wird ein Gleichgewichtszustand der Quermagnetisierung einer Schicht erzeugt. Unmittelbar vor und nach den Hochfrequenzimpulsen $RF_n$ bilden sich, wie in der bereits erwähnten Publikation von Freeman, Hill in "Journal of Magnetic Resonance, 4 (1971), 366 bis 383" erläutert, Focussierungspunkte der Quermagnetisierung aus, die man sich in erster Näherung als FID-Signal $S^+$ und als halbes Echo $S^-$ vorstellen kann. Durch den negativen Gradientenimpuls $G_{y1}$ wird das erste FID-Signal $S^+$ dephasiert und mit dem anschließenden positiven Gradientenimpuls $G_{y2}$ wieder rephasiert, so daß aus dem FID-Signal $S^+$ ein Echosignal $S_1$ entsteht.

Unter dem Gradientenimpuls $G_{y3}$ wird zusammen mit der Wirkung des Gradientenimpulses $G_{y4}$ auch das halbe Echosignal $S^-$ zu einem vollständigen Echosignal $S_2$.

Bei Flip-Winkeln größer als $50°$ gilt für die Signalamplitude von $S_2$ näherungsweise:

$$S_2 = S_1 \, ex \, (- 2 \, T_R/T_2)$$

Dabei ist $T_R$ die Repetitionszeit der dargestellten Pulssequenz.

Diese Abhängigkeit der Signalintensität kann zur Bestimmung der Querrelaxationszeit $T_2$ herangezogen werden.

Die gewonnenen Signale $S_1$ und $S_2$, die durch die Phasencodiergradienten $G_{x1}$, $G_{x2}$ in x-Richtung phasencodiert und durch die als Auslesegradienten wirkenden Gradientenimpulse $G_{y2}$ und $G_{y3}$ in y-Richtung frequenzcodiert sind, werden zur Bilderzeugung nach dem zweidimensionalen Fourier-Transformationsverfahren, wie es in der US-PS 40 70 611 beschrieben ist, herangezogen. Dabei kann man bei praktisch unveränderter Meßzeit durch

Verwendung der Signale $S_1$ und $S_2$ zwei Bilder mit unterschiedlichem $T_2$-Kontrast erstellen. Je nach Anwendungsfall können sich die Informationsinhalte der Bilder ergänzen und sind damit von erhöhtem diagnostischem Wert.

FIG 5 zeigt ein zweites Ausführungsbeispiel der Erfindung, bei dem anstelle des zweidimensionalen Fourier-Transformationsverfahrens ein dreidimensionales Fourier-Transformationsverfahren eingesetzt wird. Hierbei entfällt der Schichtselektionsgradient $G_{z1}$ mit den negativen Zusatzgradienten $G_{z2}$ und $G_{z3}$. Dafür werden vor und nach jedem Hochfrequenzimpuls RF Phasencodiergradienten $G_{z4}$ und $G_{z5}$ eingeschaltet, die zueinander invers sind. Ansonsten bleibt die Anregesequenz unverändert. Das dreidimensionale Fourier-Transformationsverfahren, das ebenfalls in der US-PS 40 70 611 beschrieben ist, bietet den Vorteil eines erhöhten Signal-/Rauschverhältnisses und die Möglichkeit, nachträglich jede beliebige Schicht im Meßvolumen rekonstruieren zu können.

**Patentansprüche**

1. Verfahren zum Betrieb eines Kernspin-Tomographiegerätes zur Untersuchung eines Objektes (5) mit Hilfe der kernmagnetischen Resonanz, mit Spulen (1,2,3,4,7,8) zum Anlegen von magnetischen Grund- und Gradientenfeldern an das Untersuchungsobjekt (5) und einer Hochfrequenzeinrichtung (9,16), die das Untersuchungsobjekt (5) mit einer Folge von Hochfrequenzimuplsen bestrahlt und die vom Untersuchungsobjekt ausgesandten Kernresonanzsignale erfaßt, wobei die für die Bilderzeugung notwendigen Signale in folgenden Schritten gewonnen werden:

a) während eines ersten Zeitabschnittes wird ein Hochfrequenzimpuls (RF) eingestrahlt;

b) nach dem Hochfrequenzimpuls (RF) wird während eines zweiten Zeitabschnittes ein erster Gradientenimpuls ($G_{y1}$) in einer ersten Richtung (y) als Dephasiergradient und ein erster Phasencodier-Gradientenimpuls ($G_{x1}$) in mindestens einer zweiten Richtung (x) eingeschaltet;

c) während eines dritten Zeitabschnittes wird als Auslesegradient ein zweiter Gradientenimpuls ($G_{y2}$) in der ersten Richtung (y) eingeschaltet, der gegenüber dem ersten Gradientenimpuls ($G_{y1}$) in der ersten Richtung invertiert ist und ein dabei entstehendes erstes Kernresonanzsignal (S1) wird ausgelesen;

d) während eines vierten Zeitabschnittes wird ein dritter Gradientenimpuls ($G_{y3}$) in der ersten Richtung eingeschaltet und ein dabei entstehendes zweites Kernresonanzsignal (S2) wird ausgelesen;

e) während eines fünften Zeitabschnittes wird ein zum dritten Gradientenimpuls ($G_{y3}$) invertierter vierter Gradientenimpuls ($G_{y4}$) in der ersten Richtung und ein zum ersten Phasencodier-Gradientenimpuls ($G_{x1}$) invertierter zweiter Phasencodier-Gradientenimpuls ($G_{x2}$) in der zweiten Richtung eingeschaltet;

f) die Schritte a) bis e) werden n-mal mit verschiedenen Werten der Phasencodier-Gradientenimpulse ($G_x$) wiederholt.

2. Verfahren zum Betrieb eines Kernspin-Tomographiegerätes nach Anspruch 1, **dadurch gekennzeichnet,** daß jeder Hochfrequenzimpuls (RF) zusammen mit einem Schichtauswahlgradienten ($G_{z1}$) in einer dritten Richtung eingestrahlt wird und daß vor und nach jedem Schichtauswahlgradienten ($G_{z1}$) je ein Gradientenimpuls ($G_{z2}$, $G_{z3}$) in entgegengesetzter Richtung eingeschaltet wird.

3. Verfahren zum Betrieb eines Kernspin-Tomographiegerät nach Anspruch 1, **dadurch gekennzeichnet,** daß vor und nach jedem Hochfrequenzimpuls (RF) je ein Phasencodier-Gradientenimpuls ($G_{z4}$, $G_{z5}$) in der dritten Richtung eingeschaltet wird, wobei diese beiden Phasencodier-Gradientenimpulse entgegengesetzte Vorzeichen haben.

**Claims**

1. A method for operating a nuclear spin tomographic apparatus for examining an object (5) with the aid of nuclear magnetic resonance, with coils (1,2,3,4,7,8) for applying magnetic base and gradient fields to the object under examination (5) and a high-frequency device (9,16), which irradiates the object under examination (5) with a series of high-frequency pulses and which detects nuclear resonance signals emitted by the object under examination, wherein the signals which are necessary for the image generation are gained in the following steps:

a) during a first time interval a high-frequency pulse (RF) is irradiated;

b) after the high-frequency pulse (RF) during a second time interval a first gradient pulse ($G_{y1}$) is applied in a first direction (y) as dephaser gradient and a first phase coder gradient pulse ($G_{x1}$) is applied in at least a second direction (x);

c) during a third time interval a second gradient pulse ($G_{y2}$), which is inverted relative to the first gradient pulse ($G_{y1}$) in the first direction, is applied as read-out gradient in the first direction (y), and a first nuclear resonance signal (S1) forming in this process is read out;

d) during a fourth time interval a third gradient pulse ($G_{y3}$) is applied in the first direction and a second nuclear resonance signal (S2) forming in this process is read out;

e) during a fifth time interval a fourth gradient pulse ($G_{y4}$), inverted to the third gradient pulse ($G_{y3}$), is applied in the first direction, and a second phase coder gradient pulse ($G_{x2}$), inverted to the first phase coder gradient pulse ($G_{x1}$), is applied in the second direction;

f) the steps a) to e) are repeated n times with various values of the phase coder gradient pulses ($G_x$).

2. A method for operating a nuclear spin tomographic apparatus according to claim 1, characterised in that each high-frequency pulse (RF) is irradiated together with a layer selection gradient ($G_{z1}$) in a third direction, and in that before and after each layer selection gradient ($G_{z1}$) each gradient pulse is applied ($G_{z2}$, $G_{z3}$) in the opposing direction.

3. A method for operating a nuclear spin tomographic apparatus according to claim 1, characterised in that before and after each high-frequency pulse (RF) a phase coder gradient pulse ($G_{z4}$, $G_{z5}$) is applied in the third direction, wherein these two phase coder gradient pulses have opposing signs.

**Revendications**

1. Procédé pour faire fonctionner un dispositif de tomographie à résonance magnétique nucléaire pour l'examen d'un objet (5) à l'aide de la résonance magnétique nucléaire, et comportant des bobines (1,2,3,4,7,8) pour appliquer un champ magnétique de base et des champs magnétiques irrotationnels à l'objet d'examen (5), et un dispositif à haute fréquence (9,16), qui applique à l'objet d'examen (5) une suite d'impulsions à haute fréquence et qui détecte des signaux de résonance nucléaire émis par l'objet d'examen, et selon lequel on obtient les signaux nécessaires pour la formation des images, en mettant en oeuvre les pas suivants:

a) pendant un premier intervalle de temps, on applique une impulsion à haute fréquence (RF);

b) après l'impulsion à haute fréquence (RF), pendant un second intervalle de temps on applique une première impulsion de gradient ($G_{y1}$) dans une première direction (y) en tant que gradient de déphasage et une première impulsion de gradient de codage de phase ($G_{x1}$) dans au moins une seconde direction (x);

c) pendant un troisième intervalle de temps, on applique dans la première direction (y), en tant que gradient de lecture, une seconde impulsion de gradient ($G_{y2}$), qui est inversée par rapport à la première impulsion de gradient ($G_{y1}$) envoyée dans la première direction, et on lit un premier signal de résonance nucléaire (S1) obtenu;

d) pendant un quatrième intervalle de temps, on applique une troisième impulsion de gradient ($G_{y3}$) dans la première direction et on lit un second signal de résonance nucléaire (S2) obtenu;

e) pendant un cinquième intervalle de temps, on applique une quatrième impulsion de gradient ($G_{y4}$), inversée par rapport à la troisième impulsion de gradient ($G_{y3}$) dans la première direction, et une seconde impulsion de gradient de codage de phase ($G_{x2}$), inversée par rapport à la première impulsion de gradient de codage de phase ($G_{x1}$), dans la seconde direction;

f) on répète les pas a) à e) n fois avec différentes valeurs pour les impulsions de gradient de codage de phase ($G_x$).

2. Procédé pour faire fonctionner un appareil de tomographie à résonance magnétique nucléaire suivant la revendication 1, caractérisé par le fait qu'on émet chaque impulsion à haute fréquence (RF) conjointement avec un gradient de sélection de couche ($G_{z2}$), dans une troisième direction et qu'avant et après l'application de chaque gradient de sélection de couche ($G_{z1}$), on applique respectivement une impulsion de gradient ($G_{z2}$, $G_{z3}$) dans la direction opposée.

3. Procédé pour faire fonctionner un appareil de tomographie à résonance magnétique nucléaire suivant la revendication 1, caractérisé par le fait qu'avant et après chaque impulsion à haute fréquence (RF), on applique respectivement une troisième impulsion de gradient de codage de phase ($G_{z4}$, $G_{z5}$) dans la troisième direction, ces deux impulsions de gradient de codage de phase possédant des signes opposés.

**FIG 1**

FIG 2

FIG 3

FIG 4

FIG 5